# DEMANDE DE BREVET EUROPEEN

(11) **EP 0 889 565 A1**
(43) Date de publication de la demande: **07.01.1999**
(21) Numéro de dépôt: 98400678.3
(22) Date de dépôt: 23.03.1998
(51) Int. Cl.: H02B 1/42, H05K 7/14

(54) **Enveloppe pour appareillages électriques**

(30) Priorité: 21.04.1997 FR 9705005
(71) Demandeur: SCHNEIDER ELECTRIC SA, 92100 Boulogne Billancourt (FR)
(72) Inventeur: Deschamps, Jean-Christophe, 21700 Nuits Saint Georges (FR); Schmit, Francis, 21121 Fontaine les Dijon (FR)

(57) **Abrégé**

Enveloppe pour appareillages électriques comprenant des organes électriques (21) de commande ou visualisation, qui sont portés par une paroi (23) de l'enveloppe en étant accessibles de l'extérieur, une unité (20) de traitement ou commande de ces organes, qui est logée à l'intérieur de l'enveloppe, et un dispositif d'interface électrique (1) entre les organes (21) et l'unité (20), le dispositif d'interface (1) étant constitué d'un boîtier (10) comprenant un corps (11) qui loge une carte à circuit imprimé et intègre une rangée de bornes de connexion (30) et un connecteur (61) pour relier la carte à circuit imprimé aux organes (21) et respectivement à l'unité (20), caractérisée en ce que le dispositif d'interface (1) comprend une partie de fixation (12a) montée sur la face interne de la paroi (23) de l'enveloppe à proximité des organes (21), et les bornes (30) du dispositif (1) sont du type à connexion rapide.

## Description

La présente invention concerne une enveloppe pour appareillages électriques comprenant une unité de traitement telle qu'un automate programmable, des organes électriques de commande ou de visualisation tels que des boutons-poussoirs et des voyants susceptibles d'être exploités ou commandés par l'unité de traitement, et un dispositif d'interface électrique entre l'unité de traitement et les organes électriques. Le dispositif d'interface est constitué d'un boîtier comprenant un corps qui loge une carte à circuit imprimé et intègre une rangée de bomes de connexion et un connecteur pour relier respectivement la carte à circuit imprimé aux organes électriques et à l'unité de traitement.

Les appareillages électriques sont généralement agencés dans l'enveloppe de manière que l'unité de traitement et le dispositif d'interface soient logés à l'intérieur de l'enveloppe tandis que les organes électriques sont portés par une paroi de l'enveloppe et accessibles de l'extérieur.

Un tel agencement oblige cependant à utiliser des câbles de connexion électrique relativement longs pour relier les organes électriques au dispositif d'interface.

En outre, chaque organe électrique est relié aux bornes du dispositif d'interface par au moins deux câbles de connexion, ce qui présente l'inconvénient d'un système de repérage obligatoire sur les bornes et sur les extrémités de chaque câble. Le repérage est par conséquent long à mettre en place et peut engendrer un risque d'erreurs non négligeable.

Par ailleurs, un dispositif d'interface de type connu, par exemple d'après la demande de brevet FR 95 01646, comprend des bornes de connexion qui sont du type à vis; la liaison électrique des organes au circuit imprimé est par conséquent réalisée par des câbles de connexion dont les extrémités sont insérées et vissées dans les bornes. Par ce genre de câblage, l'installateur perd du temps.

L'invention a par conséquent pour but de remédier aux inconvénients inhérents aux agencements de raccordement électrique utilisés jusqu'à présent dans une enveloppe en fournissant une solution qui permette de diminuer la longueur des câbles de connexion entre le dispositif d'interface et les organes électriques tout en s'adaptant facilement à l'encombrement de la zone de câblage. Elle permet en outre de réaliser rapidement l'opération de raccordement tout en diminuant le nombre de câbles de connexion et en simplifiant leur repérage.

Selon l'invention, l'enveloppe est caractérisée en ce que le dispositif d'interface est fixé à la paroi de l'enveloppe et à proximité des organes électriques, et les bornes du dispositif sont du type à connexion rapide.

L'agencement du dispositif d'interface, ainsi intégré à l'environnement des organes électriques, réduit de façon conséquente la longueur des câbles de connexion, et permet en outre un précâblage des organes électriques en dehors de l'environnement de l'enveloppe lorsque la paroi de celle-ci est amovible.

De plus, les bornes à connexion rapide engendre une facilité et rapidité de câblage appréciable.

La description faite ci-après en regard des dessins fera ressortir les caractéristiques et les avantages de l'invention. Aux dessins annexés:
- la figure 1 est une enveloppe de distribution électrique selon l'invention;
- la figure 2 est une vue en perspective éclatée d'un dispositif d'interface;
- la figure 3 illustre un câble de connexion adapté à se monter sur le dispositif d'interface de la figure 2.

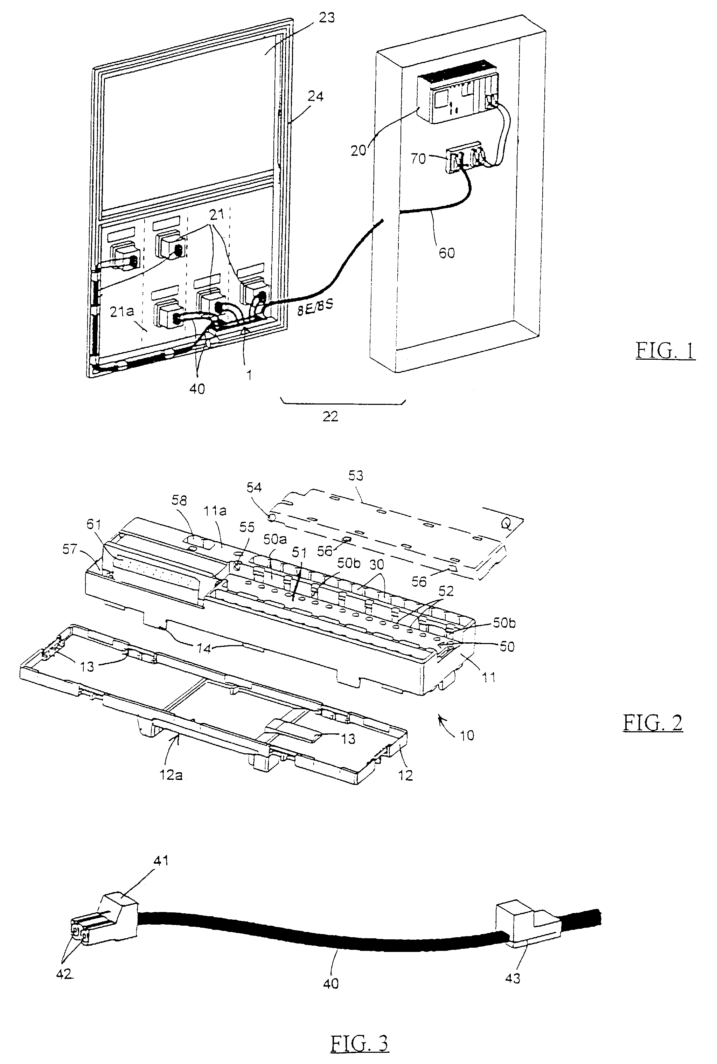

L'enveloppe 22 de distribution électrique, illustrée à la figure 1, comprend au moins une unité de traitement 20, par exemple un automate programmable, et des organes électriques 21 susceptibles d'être exploités ou commandés par cette unité.

Les organes électriques 21 sont par exemple constitués par des éléments de visualisation tels que des voyants lumineux et des éléments de commande tels que des boutons-poussoirs.

L'unité de traitement 20 est logée à l'intérieur de l'enveloppe tandis que les organes 21 sont portés par une paroi 23 de l'enveloppe et sont accessibles de l'extérieur.

La paroi 23 peut par exemple constituer le panneau de fermeture de l'enveloppe. Elle comporte sur sa face interne un châssis 24 sur lequel sont fixées des platines 21a servant de support aux organes 21.

L'unité 20 et les organes 21 sont reliés électriquement via un dispositif d'interface 1. Le raccordement électrique du dispositif d'interface 1 aux organes 21 et à l'unité 20 est réalisé par des câbles de connexion 40 et respectivement un cordon électrique 60 spécifiquement adaptés.

Le dispositif d'interface 1 est destiné à être implanté sur la paroi 23 et à proximité des organes 21.

Le dispositif d'interface 1, illustré à la figure 2, est un boîtier 10 ayant une forme générale parallélépipédique et oblongue. Il présente un gabarit de faible encombrement pour être adapté à se loger dans l'environnement des organes 21.

Le boîtier 10 est constitué d'un corps 11, d'une carte à circuit imprimé non visible sur les dessins, et d'un socle 12. Le corps 11 et le socle 12 sont en matière plastique.

Le socle 12 est fixé à l'arrière du corps 11 afin de protéger la carte à circuit imprimé et fermer le corps du boîtier. La fermeture arrière est réalisée par de moyens d'accrochage et d'encliquetage 13 prévus sur le socle 12 qui coopèrent avec des moyens complémentaires de retenue 14 du corps 11.

Le boîtier 10 comprend une partie de fixation 12a qui est constituée par la partie arrière de son socle 12. La partie de fixation 12a est montée par des moyens adaptés, soit à une platine 21a, soit directement au châssis 24.

Le corps 11 du boîtier intègre sur une partie de sa façade 11a, de façon longitudinale, une première rangée de bornes de connexion 30 alignées. De préférence, les bornes de connexion sont au plus égal au nombre de huit afin de modérer l'encombrement du boîtier 10.

Chaque borne 30 est une borne à fiche qui est munie de deux broches de connexion, non illustrées, soudée au circuit imprimé. Le raccordement d'un appareillage 21 à une borne 30 est réalisé par au moins un câble de connexion 40 (figure 3) qui comprend à l'une de ses extrémités un connecteur 41 à deux éléments de connexion femelles 42 pour s'enficher sur les broches de connexion de la borne. Le câble 40 comprend à son autre extrémité un connecteur 43 adapté au type de connexion de l'appareillage 21. Avantageusement, ce connecteur est coulissant sur le câble pour adapter la longueur de ce dernier entre le dispositif 1 et l'appareillage 21; lorsque la longueur est déterminée, le connecteur est arrêté sur le câble par des moyens de serrage appropriés, le connecteur étant de préférence auto-dénudant.

Le corps 11 comprend par ailleurs, au-dessus de la carte à circuit imprimé, un évidement central et longitudinal 50 de longueur sensiblement égal à la rangée de bornes 30.

L'évidement 50 présente un fond 51 qui comporte une rangée d'orifices 52 alignés et disposés latéralement en regard des bornes de connexion 30. Les orifices 52 sont en correspondance avec des éléments électriquement conducteurs de la carte à circuit imprimé, telles que des pistes conductrices, qui sont reliées aux broches de connexion des bornes 30. Les pièces conductrices sont ainsi accessibles pour un test électrique des bornes 30 par les orifices 52.

Le fond 51 porte aussi une étiquette de repérage électrique préétabli pour chacune des bornes de connexion 30.

L'évidement 50 présente une profondeur qui permet de loger un couvercle pivotant 53 de manière que son plan avant Q soit situé au niveau de la façade 11a du corps 11 en position fermée. Le couvercle 53 et les parois latérales longitudinales 50a de l'évidement 50 comportent à leurs extrémités des pivots 54 et des encoches 55 aptes à coopérer entre eux permettant l'articulation du couvercle. La fermeture du couvercle 53 est réalisée grâce à des pattes 56 qui sont encliquetables dans des ouvertures 50b ménagées dans les parois latérales 50a de l'évidement central.

Le couvercle 53 est de préférence transparent pour rendre visible l'étiquette de repérage préétabli du fond 51 de l'évidement 50. Le couvercle transparent peut néanmoins porter sur sa façade une étiquette de repérage électrique propre à l'utilisateur qui est adaptée à se glisser contre des épaulements disposés sur sur la face interne du couvercle.

Une deuxième rangée de bornes de connexion 30 alignées peut être prévue parallèlement à la première et symétriquement à l'évidement 50. Des orifices de test 52 supplémentaires sont par conséquent ménagés dans le fond 51.

Le corps 11 du boîtier comprend une ouverture 57 intégrée dans la façade 11a pour le passage d'un connecteur 61, par exemple multi-points, de liaison avec l'unité de traitement 20 qui est monté sur la carte à circuit imprimé. La liaison électrique est faite par le cordon électrique 60 adapté et muni d'un connecteur multi-points complémentaire. Le connecteur 61 et le cordon électrique 60 peuvent être en variante adaptés à une connectique pour bus de terrain, du type AS-Interface par exemple.

Dans le cas de l'utilisation d'un connecteur multi-points, il est prévu entre le dispositif d'interface 1 et l'unité 20 un boîtier de répartition 70 pour y connecter le cordon électrique 60, les informations provenant ou à destination de l'unité 20 au boîtier 70 étant ensuite transmises via deux cordons distincts qui sont adaptés aux entrées de l'unité.

Enfin, du côté de l'ouverture 57, la façade 11a du boîtier peut être dotée d'une ouverture supplémentaire 58 pour le passage d'une prise de connexion de type alimentation à basse tension montée sur la carte à circuit imprimé. Cette prise peut être utilisée pour alimenter un type donné d'organe 21.

L'agencement du raccordement électrique des organes à l'unité de traitement via le dispositif d'interface dans l'enveloppe est fait de la manière suivante:

L'unité de traitement 20 est montée à l'intérieur de l'armoire, tandis que les organes 21 et le dispositif d'interface 1 sont fixés au châssis 24 de la paroi 23. Le dispositif d'interface 1 est monté au plus proche des organes 21 de sorte que la longueur des câbles de connexion 40 est minimisée.

En fonction du nombre d'organes 21 à installer, il va de soi que plusieurs dispositifs d'interface 1 peuvent leur être associés.

Les câbles de connexion 40 sont d'abord câblés aux organes 21, leurs extrémités associées étant adaptées au type de bornes de chaque organe.

L'installateur peut ensuite établir une étiquette de repérage électrique notifiant l'ensemble des connexions des organes et la glisser dans le couvercle transparent 53 du dispositif d'interface.

Les câbles 40 sont ensuite acheminés vers le dispositif 1 où leurs extrémités 41 sont enfichées dans les bornes 30.

Enfin le dispositif d'interface 1 est connecté à l'unité 20 via le cordon électrique 60.

On note qu'un appareillage 21 est relié, selon sa fonction, par au moins un câble de connexion 40 qui intègre une ligne de conduction d'aller et une ligne de conduction de retour, ce qui ne nécessite pas l'utilisation de deux câbles ou fils distincts comme dans l'art antérieur. Un tel câble permet par conséquent d'utiliser un simple élément de repérage apposé sur le connecteur 41, et pouvant porter par exemple la fonction de l'appareil 21 au lieu de la destination du câble, alors que pour du câblage de type fil à fil, il est nécessaire de repérer chaque fil, l'inscription de sa destination étant obligatoire.

## Revendications

1. Enveloppe pour appareillages électriques comprenant des organes électriques (21) de commande ou visualisation, qui sont portés par une paroi (23) de l'enveloppe en étant accessibles de l'extérieur, une unité (20) de traitement ou commande de ces organes, qui est logée à l'intérieur de l'enveloppe, et un dispositif d'interface électrique (1) entre les organes (21) et l'unité (20), le dispositif d'interface (1) étant constitué d'un boîtier (10) comprenant un corps (11) qui loge une carte à circuit imprimé et intègre une rangée de bornes de connexion (30) et un connecteur (61) pour relier la carte à circuit imprimé aux organes (21) et respectivement à l'unité (20), caractérisée en ce que le dispositif d'interface (1) comprend une partie de fixation (12a) montée sur la face interne de la paroi (23) de l'enveloppe à proximité des organes (21), et les bornes (30) du dispositif (1) sont du type à connexion rapide.

2. Enveloppe selon la revendication 1, caractérisée en ce que la paroi (23) porte sur sa face interne un châssis (24) sur lequel sont montées des platines (21a) de support pour les organes électriques (21), l'une des platines (21a) servant de support de fixation au dispositif d'interface (1).

3. Enveloppe selon la revendication 1, caractérisée en ce que la paroi (23) porte sur sa face interne un châssis (24) sur lequel est fixé le dispositif d'interface (1).

4. Enveloppe selon la revendication 1, caractérisée en ce que les bomes (30) du dispositif d'interface sont du type à broches de connexion et le raccordement électrique entre les bornes (30) et les organes (21) est effectué grâce à des câbles de connexion (40) munis chacun à au moins l'une de leurs extrémités d'un connecteur (41) qui est adapté à s'enficher dans les broches de connexion d'une borne (30).

5. Enveloppe selon la revendication 4, caractérisée en ce que chaque borne de connexion (30) du dispositif d'interface comprend deux broches de connexion, et le connecteur (41) qui lui est associé comprend deux éléments de connexion femelles (42) correspondants destinés à s'enficher respectivement sur les deux broches de connexion.

6. Enveloppe selon la revendication 1, caractérisée en ce que le corps (11) du dispositif d'interface comprend un évidement (50) de longueur sensiblement égale à celle de la rangée de bornes (30), ledit évidement comportant un fond (51) qui est situé au-dessus de la carte à circuit imprimé et qui comprend des orifices (52) disposés latéralement en regard de chacune des bornes de connexion (30), et venant en correspondance avec des éléments électriquement conducteurs de la carte à circuit imprimé pour les rendre accessibles à des tests électriques, les pièces conductrices étant reliées aux bornes de connexion.

7. Enveloppe selon la revendication 6, caractérisée en ce que le corps (11) du dispositif d'interface intègre une deuxième rangée longitudinale de bornes de connexion qui est parallèle à la première rangée de bornes et symétrique par rapport à l'évidement (50), le fond (51) de l'évidement central comprenant des orifices de test (52) supplémentaires associés à la deuxième rangée de bornes.

8. Enveloppe selon la revendication 6, caractérisée en ce que l'évidement (50) du dispositif d'interface est obturé par un couvercle (53) dont la face avant est adaptée à porter une étiquette de repérage électrique des bornes de connexion propre à l'utilisateur.

9. Enveloppe selon la revendication 8, caractérisée en ce que le couvercle (53) est monté pivotant sur des pivots (54) portés par les extrémités latérales de l'évidement (50) et présente des pattes (56) encliquetables dans des ouvertures (50b) ménagées dans les parois de l'évidement.

10. Enveloppe selon la revendication 1, caractérisée en ce que le corps (11) du dispositif d'interface comporte une ouverture (58) pour le passage d'une prise d'alimentation à basse tension qui est montée sur la carte à circuit imprimé.

11. Enveloppe selon la revendication 4, caractérisée en ce que le câble de connexion (40) est muni à son autre extrémité d'un connecteur (43) auto-dénudant et apte à coulisser sur le câble avant la détermination de longueur de câble nécessaire pour le câblage.
